# EUROPEAN PATENT SPECIFICATION

(11) **EP 0 354 280 B1**
(45) Date of publication and mention of the grant of the patent: **29.12.1993**
(21) Application number: 88307378.5
(22) Date of filing: 10.08.1988
(51) Int. Cl.: H01L 31/02, H01L 27/14

(54) **Image sensor and photo-electric conversion element therefor**
Bilddetektor und entsprechendes photoelektrisches Umwandlungselement
Détecteur d'images et élément de conversion photoélectrique correspondant

(43) Date of publication of application: 14.02.1990
(73) Proprietor: SEIKO INSTRUMENTS INC., Tokyo 136 (JP)
(72) Inventor: Machida, Satoshi, Koto-ku Tokyo (JP); Mukainakano, Hiroshi, Koto-ku Tokyo (JP); Kawahara, Yukito, Koto-ku Tokyo (JP)
(74) Representative: Miller, Joseph

(56) References cited:
- DE-A- 3 626 504
- US-A- 4 001 863
- PATENT ABSTRACTS OF JAPAN, vol. 8, no. 209 (E-268)[1646], 22nd September 1984; & JP-A-59 94 469
- PATENT ABSTRACTS OF JAPAN, vol. 11, no. 51 (E-480)[2498], 17th February 1987; & JP-A-61 214 564
- PATENT ABSTRACTS OF JAPAN, vol. 11, no. 27 (E-474)[2474], 27th January 1987; & JP-A-61 196 573
- PATENT ABSTRACTS OF JAPAN, vol. 7, no. 4 (E-151)[1149], 8th January 1983; &JP-A-57 164 585

## Description

This invention concerns an image sensor, and a photo-electric conversion element therefor, for converting an optical signal or signals into an electrical signal or signals and, although the invention is not so restricted, it more particularly concerns a facsimile machine or an image scanner provided with such an image sensor.

A photo-electric conversion element for an image sensor is known to the applicants which comprises a photo-electric conversion region for effecting photo-electric conversion, and a passivation film which covers the photo-electric conversion region and which is composed of two different layers. In this photo-electric conversion element, however, the thickness of each of the two layers is comparable to the wavelength of the incident light, while the refractive indices of the two layers are not the same. Consequently, at the boundary surface between the two layers, there is interference between the reflected light and the incident light, as a result of which the transmittance of the incident light depends upon its wavelength.

Patent Abstracts of Japan Volume 8, No. 209 (E-268) (1646) 22 September 1984 (corresponding to JP-A-59-94469) discloses a photo-electric converter comprising an amorphous Si photoelectric conversion region 7 passivated by an SiO₂ layer 6 and protected by an epoxy resin coating 7 having a thickness of approximately 5 to 10µm. The arrangement also includes an upper In₂O₃ electrode 5a-5e.

According, therefore to the present invention, there is provided a photo-electric conversion element for converting an optical signal into an electrical signal comprising a photo-electric conversion region for effecting photo-electric conversion, a first passivation film which covers the photo-electric conversion region and a second passivation film which overlies the first passivation film so as to directly overlie at least the major portion of the photo-electric conversion region, characterised in that the first and second passivation films are of substantially the same refractive index so as to eliminate multi-interference in the first passivation film, the thickness of the second passivation film being at least ten times the wavelength of the incident light which is arranged to fall onto the photo-electric conversion region.

The first passivation film may comprise an oxide layer and the second passivation film may comprise a resin layer.

Preferably a portion of the first passivation film, which is disposed laterally of the photo-electric conversion region, is covered by a light shielding layer.

Preferably a nitride layer covers the light shielding layer.

The arrangement may be that a minor portion only of the nitride layer directly overlies the photo-electric conversion region.

The photo-electric conversion region may be formed in a semiconductor substrate. The invention also comprises an image sensor comprising at least one photo-electric conversion element for converting an optical signal into an electrical signal, and a light source arranged to direct light of a predetermined wavelength or wavelengths onto the or each photo-electric conversion element, the or each photo-electric conversion element comprising a photo-electric conversion region for effecting photo-electric conversion, and a first passivation film which covers the photo-electric conversion region and a second passivation film which overlies the first passivation film so as to directly overlie at least the major portion of the photo-electric conversion region, characterised in that the first and second passivation films are of substantially the same refractive index so as to eliminate multi-interference in the first passivation film, the thickness of the second passivation film being at least ten times that of the said predetermined wavelength, or of any of the said wavelengths.

The image sensor may comprise a plurality of photo-electric conversion elements whose electrical outputs are passed to a shift register by way of a shift gate circuit.

The light source may be a light-emitting diode.

The invention is illustrated, merely by way of example, in the accompanying drawings, in which:-
Figure 1 is a sectional view of a photo-electric conversion element for an image sensor according to the present invention,
Figure 2 is a sectional view similar to that of Figure 1 but showing a photo-electric conversion element known to the applicants, and
Figure 3 is a plan view of an image sensor provided with a plurality of photo-electric conversion elements as shown in Figure 1.

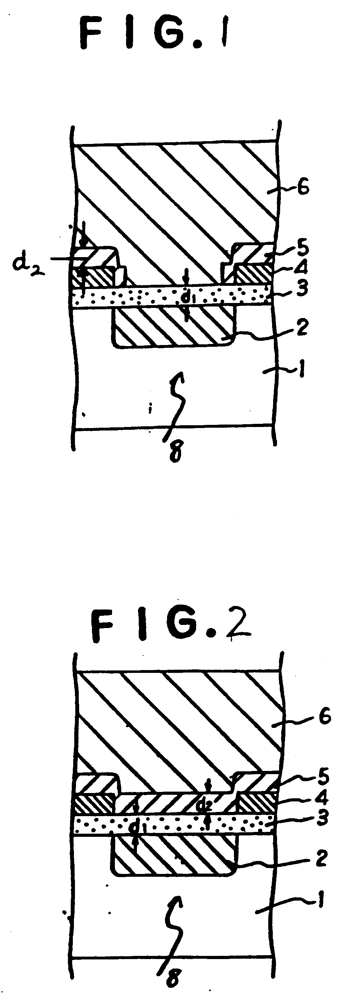

As indicated above, Figure 2 shows a photo-electric conversion element 8 known to the applicants. The photo-electric conversion element 8 comprises a photo-electric conversion region 2, such as a pn junction, which is formed in a semiconductor substrate 1. The photo-electric conversion region 2 is sequentially covered with an oxide layer 3, a nitride layer 5 and a resin layer 6. The portion of the oxide layer 3 is externally of the photo-electric conversion region 2 is covered with a light shielding layer 4 made, for example, of aluminium so as to block incident light.

However, in the photo-electric conversion element 8 shown in Figure 2, the thickness d₁ of the oxide layer 3 and the thickness d₂ of the nitride layer 5 are comparable to the wavelength of the incident light, and the refractive indices of the semiconductor substrate 1, the oxide layer 3, the nitride layer 5 and the resin layer 6 are different so that the reflected light and the incident light are in multi-interference with each other at the boundary surfaces between adjacent layers. Due to this multi-interference, transmittance of the incident light depends on the wavelength of the incident light.

Further, light transmittance of the same wavelength varies according to the thickness d₁ and d₂. In the actual semiconductor fabrication process, it is difficult to keep the thicknesses d₁ and d₂ constant, so that the spectral sensitivity of the photo-electric conversion element 8 of Figure 2 varies. For this reason, the sensitivity of an individual photo-electric conversion element is not maintained at a fixed given value when an LED is utilized as a light source.

In the photo-electric conversion element according to the present invention which is shown in Figure 1, however, a photo-electric conversion region 2 such as a pn junction is formed in a semiconductor substrate 1. An oxide layer 3, which includes a gate oxide layer and intermediate passivation layer, is formed on the semiconductor substrate 1 by a semiconductor fabrication process.

Next, a light shielding layer 4 of aluminium is formed on the oxide layer 3 by an electro-conductive formation process, the light shielding layer 4 covering only the portion of the oxide layer 3 laterally of the photo-electric conversion region 2. Then, a nitride layer 5 is formed as a passivation layer so as to extend throughout the entire surface of the semiconductor substrate 1. Thereafter, a portion of the nitride layer 5 disposed above the photo-electric conversion region is removed by etching so that only a very minor part of the portion of the oxide layer 3 which directly overlies the photo-electric conversion region 2 is covered by the nitride layer 5. At this time, the light shielding layer 4 is covered with the nitride layer 5 so as to protect the light shielding layer 4 from thermal stress. The nitride layer 5, however, is not needed if the reliability of the semiconductor device can be ensured. The so formed semiconductor photo-electric conversion element 8 is mounted on a base plate (not shown) and is resin-moulded to provide it with a protecting resin layer 6. The resin layer 6 is transparent to transmit the incident light and its refractive index is selected to be substantially identical to that of the oxide layer 3 so as to effectively eliminate multi-interference in the oxide layer 3. Thus the oxide layer 3 may be an SiO₂ layer having a refractive index of 1.46 while the resin layer 6 may have a refractive index of about 1.45. The nitride layer 6, however, may be a Si₃N₄ layer having a refractive index of 2.05.

The thickness of the resin layer 6 is arranged to be some ten times as great as the wavelength of incident light. In the embodiment shown in Figure 1, the photo-electric conversion region 2 is covered by an optically thick multi-layer passivation film composed of the oxide layer (the first passivation film) 3 and the resin layer (the second passivation film) 6 to eliminate the interference of the incident light, the whole of the first and second passivation films 3,6 being of substantially the same refractive index.

The multi-layer passivation film 3,6 has a sufficient light transmittance so that the intensity of light irradiated onto the photo-electric conversion region 2 is maintained constant even if the thickness d₁ of the oxide layer 3 and the thickness of the resin layer 6 are changed.

In the present invention, the photo-electric conversion element is not necessarily of the semi-conductor device type, but the refractive index of each layer 3,6 is substantially the same so as to avoid multi-interference.

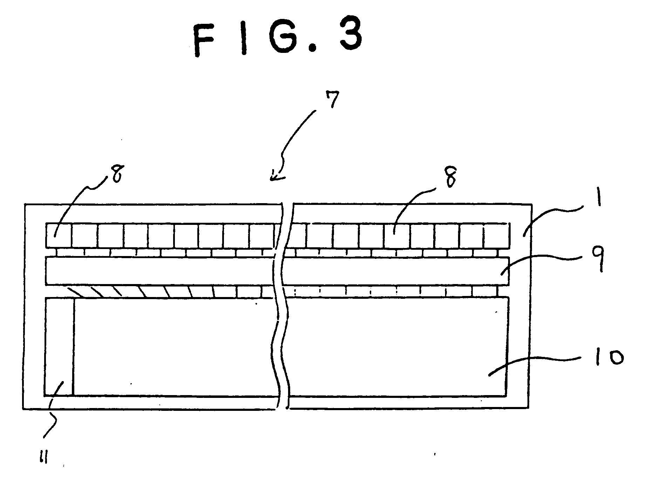

Figure 3 shows a plan view of an image sensor 7 according to the present invention which is provided with a plurality of photo-electric conversion elements 8 as shown in Figure 1. Thus the photo-electric conversion elements 8 may be pn junction photo-diodes which are linearly arranged on the semiconductor substrate 1. The image sensor 7 is provided with a light-emitting diode or other light source (not shown) which is arranged to direct light of a predetermined wavelength or wavelengths onto the photo-electric conversion region 2 of each of the photo-electric conversion elements 8, the thickness of the second passivation film 6 of each such element 8 being at least ten times that of the said predetermined wavelength, or any of the said wavelengths.

A shift gate circuit 9 and a CCD analog shift register 10 is provided adjacent to the conversion elements 8. An output circuit 11 is connected to the shift register 10.

Each of the respective photo-electric conversion elements 8 produces an electrical charge signal in proportion to the amount of incident light received by it. The electrical charge signal is transferred to the CCD analog shift register 10 through the shift gate circuit 9. The electrical charge signal fed to the shift register 10 is sequentially transferred to the output circuit 11, where the electrical charge signal is converted into a voltage signal and is outputted.

In the image sensor of Figure 3, the refractive index of the first and second passivation films 3, 6 of each photo-electric conversion element 8 is substantially uniform throughout so that reflection of the incident light is caused only at the boundary between the photo-electric conversion region 2 and the first passivation film 3, and at the outer surface of the second passivation film 6. Further, the thickness of the second passivation film 6 is arranged to be at least substantially ten times as great as the wavelength of the incident light so that interference is not caused between the reflected light and the incident light. Consequently, if the light transmittance of the passivation film 3,6 is sufficiently great, the intensity of light received by the photo-electric conversion region 2 is constant so as to maintain the sensitivity at a given value irrespective of the thickness of the multi-layer passivation film 3,6.

## Claims

1. A photo-electric conversion element (8) for converting an optical signal into an electrical signal comprising a photo-electric conversion region (2) for effecting photo-electric conversion, a first passivation film (3) which covers the photo-electric conversion region (2) and a second passivation film (6) which overlies the first passivation film (3) so as to directly overlie at least the major portion of the photo-electric conversion region (2), characterised in that the first and second passivation films (3,6) are of substantially the same refractive index so as to eliminate multi-interference in the first passivation film (3), the thickness of the second passivation film (6) being at least ten times the wavelength of the incident light which is arranged to fall onto the photo-electric conversion region (2).

2. A photo-electric conversion element as claimed in claim 1 characterised in that the first and second passivation films (3,6) respectively comprise an oxide layer (3) and a resin layer (6).

3. A photo-electric conversion element as claimed in claim 1 or 2 characterised in that a portion of the first passivation film (3) which is disposed laterally of the photo-electric conversion region (2) is covered by a light shielding layer (4).

4. A photo-electric conversion element as claimed in claim 3 characterised in that a nitride layer (5) covers the light shielding layer (4).

5. A photo-electric conversion element as claimed in claim 4 in which a minor portion only of the nitride layer (5) directly overlies the photo-electric conversion region (2).

6. A photo-electric conversion element as claimed in any preceding claim characterised in that the photo-electric conversion region (2) is formed in a semiconductor substrate (1).

7. An image sensor comprising at least one photo-electric conversion element (8) for converting an optical signal into an electrical signal and a light source arranged to direct light of a predetermined wavelength or wavelengths onto the or each photo-electric conversion element (8), the or each photo-electric conversion element (8) comprising a photo-electric conversion region (2) for effecting photo-electric conversion, and a first passivation film (3) which covers the photo-electric conversion region (2) and a second passivation film (6) which overlies the first passivation film (3) so as to directly overlie at least the major portion of the photo-electric conversion region (2), characterised in that the first and second passivation films (3,6) are of substantially the same refractive index so as to eliminate multi-interference in the first passivation film (3), the thickness of the second passivation film (6) being at least ten times that of the said predetermined wavelength, or of any of the said wavelengths.

8. An image sensor as claimed in claim 7 characterised in that the image sensor comprises a plurality of photo-electric conversion elements (8) whose electrical outputs are passed to a shift register (10) by way of a shift gate circuit (9).

9. An image sensor as claimed in claim 7 or 8 in which the light source is a light-emitting diode.

## Patentansprüche

1. Photoelektrisches Umwandlungselement (8) zur Umwandlung eines optischen Signals in ein elektrisches Signal mit einem photoelektrischen Umwandlungsbereich (2) zur Durchführung der photoelektrischen Umwandlung, einem ersten, den photoelektrischen Umwandlungsbereich (2) abdeckenden Passivierungsfilm (3) und einem zweiten Passivierungsfilm (6), der so über dem ersten Passivierungsfilm liegt, daß er direkt über wenigstens dem Hauptteil des photoelektrischen Umwandlungsbereichs (2) liegt, **dadurch gekennzeichnet**, daß der erste und zweite Passivierungsfilm (3, 6) zur Eliminierung von Mehrfachinterferenz im ersten Passivierungsfilm (3) im wesentlichen den gleichen Brechungsindex besitzen und daß die Dicke des zweiten Passivierungsfilms (6) wenigstens gleich der zehnfachen Wellenlänge des auf den photoelektrischen Umwandlungsbereich (2) fallenden Lichtes ist.

2. Photoelektrisches Umwandlungselement nach Anspruch 1, **dadurch gekennzeichnet**, daß der erste bzw. zweite Passivierungsfilm (3,6) durch eine Oxidschicht (3) bzw. eine Harzschicht (6) gebildet ist.

3. Photoelektrisches Umwandlungselement nach Anspruch 1 oder 2, **dadurch gekennzeichnet**, daß ein querab zum photoelektrischen Umwandlungsbereich (2) liegender Teil des ersten Passivierungsfilms (3) durch eine Lichtabschirmungsschicht (4) abgedeckt ist.

4. Photoelektrisches Umwandlungselement nach Anspruch 3, **dadurch gekennzeichnet**, daß die Lichtabschirmungsschicht (4) durch eine Nitridschicht (5) abgedeckt ist.

5. Photoelektrisches Umwandlungselement nach Anspruch 4, **dadurch gekennzeichnet**, daß lediglich ein geringer Teil der Nitridschicht (5) direkt über dem photoelektrischen Umwandlungsbereich (2) liegt.

6. Photoelektrisches Umwandlungselement nach den vorhergehenden Ansprüchen, **dadurch gekennzeichnet**, daß der photoelektrische Umwandlungsbereich (2) in einem Halbleitersubstrat (1) ausgebildet ist.

7. Bildsensor mit wenigstens einem photoelektrischen Umwandlungselement (8) zur Umwandlung eines optischen Signals in ein elektrisches Signal und einer Lichtquelle zur Bestrahlung des oder der photoelektrischen Umwandlungselementes(e) (8) mit Licht einer vorgegebenen Wellenlänge oder Wellenlängen, wobei das oder die photoelektrischen Umwandlungselement(e) einen ersten den photoelektrischen Umwandlungsbereich (2) abdeckenden Passivierungsfilm (3) und einen zweiten Passivierungsfilm (6), der so über dem ersten Passivierungsfilm (3) liegt, daß er direkt über wenigstens dem Hauptteil des photoelektrischen Umwandlungsbereichs (2) liegt, umfaßt, **dadurch gekennzeichnet**, daß der erste und zweite Passivierungsfilm (3,6) zur Eliminierung von Mehrfachinterferenz im ersten Passivierungsfilm (3) im wesentlichen den gleichen Brechungsindex besitzen und daß die Dicke des zweiten Passivierungsfilms (6) wenigstens gleich der zehnfachen Wellenlänge oder Wellenlängen ist.

8. Bildsensor nach Anspruch 7, **dadurch gekennzeichnet**, daß er eine Vielzahl von photoelektrischen Umwandlungselementen (8) umfaßt, deren elektrische Ausgangssignale über eine Schiebegatterschaltung (9) auf ein Schieberegister (10) gegeben werden.

9. Bildsensor nach Anspruch 7 oder 8, in dem die Lichtquelle eine Lichemissionsdiode ist.

## Revendications

1. Elément de conversion photo-éleotrique (8), destiné à convertir un signal optique en un signal électrique, comprenant une région de conversion photo-électrique (2) destiné à mettre en oeuvre la conversion photo-électrique, un premier film de passivation (3) qui recouvre la région de conversion photo-électrique (2) et un deuxième film de passivation (6) placé au-dessus du premier film de passivation (3) de façon à recouvrir au moins la plus grande partie de la région de conversion photo-électrique (2), caractérisé en ce que le premier et le deuxième films de passivation (3, 6) ont essentiellement le même indice de réfraction, de façon à éliminer les interférences multiples dans le premier film de passivation (3), l'épaisseur du deuxième film de passivation (6) étant au moins égale à dix fois la longueur d'onde de la lumière incidente, disposée de façon à tomber sur la région de conversion photo-électrique (2).

2. Elément de conversion photo-électrique selon la revendication 1, caractérisé en ce que le premier film de passivation (3) et le deuxième film de passivation (6) comprennent respectivement une couche d'oxyde (3) et une couche de résine (6).

3. Elément de conversion photo-électrique selon la revendication 1 ou 2, caractérisé en ce qu'une partie du premier film de passivation (3) qui est disposé latéralement par rapport à la région de conversion photo-électrique (2) est recouverte d'une couche (4) servant de barrière à la lumière.

4. Elément de conversion photo-électrique selon la revendication 3, caractérisé en ce qu'une couche de nitrure (5) recouvre la couche servant de barrière à la lumière (4).

5. Elément de conversion photo-électrique selon la revendication 4, dans lequel seule une portion mineure de la couche de nitrure (5) recouvre directement la région de conversion photo-électrique (2).

6. Elément de conversion photo-électrique selon l'une quelconque des revendications précédentes, caractérisé en ce que la région de conversion photo-électrique (2) est formée dans un substrat semi-conducteur (1).

7. Capteur d'image comprenant au moins un élément de conversion photo-électrique destiné à convertir un signal optique en un signal électrique et une source de lumière disposée de façon à envoyer une lumière ayant une ou plusieurs longueurs d'ondes prédéterminées sur le ou chaque élément de conversion photo-électrique (8), le ou chaque élément de conversion photo-électrique (8) comprenant une région de conversion photo-électrique (2) destinée à mettre en oeuvre la conversion photo-électrique, et un premier film de passivation (3) qui recouvre la région de conversion photo-électrique (2) et un deuxième film de passivation(6) disposé au-dessus du premier film de passivation (3) de façon à recouvrir directement au moins la plus grande partie de la région de conversion photo-électrique (2), caractérisé en ce que le premier et le deuxième films de passivation (3, 6) ont essentiellement le même indice de réfraction, de façon à éliminer les interférences multiples dans le premier film de passivation (3), l'épaisseur du deuxième film de passivation (6) étant au moins égale à dix fois la longueur d'onde prédéterminée ou l'une quelconque de ces longueurs d'ondes.

8. Capteur d'image selon la revendication 7, caractérisé en ce que le capteur d'image comprend une pluralité d'éléments de conversion photo-électrique (8) dont les signaux de sortie électriques sont envoyés à un registre à décalage (10) à l'aide d'un circuit porte à décalage (9).

9. Capteur d'image selon la revendication 7 ou 8, dans lequel la source lumineuse est une diode électroluminescente.
